# EUROPÄISCHE PATENTSCHRIFT

(11) **EP 0 908 736 B1**
(45) Veröffentlichungstag und Bekanntmachung des Hinweises auf die Patenterteilung: **19.11.2008**
(21) Anmeldenummer: 98117815.5
(22) Anmeldetag: 19.09.1998
(51) Int. Cl.: G01R 27/26, H03K 17/955

(54) **Schaltungsanordnung zur Erfassung der Kapazität bzw. einer Kapazitätsänderung eines kapazitiven Schaltungs- oder Bauelementes**
Circuit for determining the capacity or the capacity change of a capacitive circuit or module
Circuit pour déterminer la capacité ou la variation de capacité d'un circuit ou module capacitif

(30) Priorität: 07.10.1997 DE 19744152
(43) Veröffentlichungstag der Anmeldung: 14.04.1999
(73) Patentinhaber: i f m electronic gmbh, D-45127 Essen (DE)
(72) Erfinder: Schulz, Jörg, 6890 Lustenau (AT)
(74) Vertreter: Gesthuysen, von Rohr & Eggert

(56) Entgegenhaltungen:
- EP-A- 0 580 947
- DE-A- 3 143 114
- DE-A- 3 940 537
- DE-A- 3 942 159
- DE-A- 19 701 899
- US-A- 4 642 555
- US-A- 4 860 232
- US-A- 5 451 940

## Beschreibung

Die Erfindung betrifft eine Schaltungsanordnung zur Erfassung der Kapazität bzw. einer Kapazitätsänderung eines kapazitiven Schaltungs- oder Bauelementes, mit einem Taktgenerator, einem von dem Taktgenerator gesteuerten Umschaltkontakt, einem Speicherkondensator, einer Spannungsquelle und einer Auswertestufe mit zwei Eingängen, bei der eine Elektrode des kapazitiven Schaltungs- oder Bauelementes mit dem Eingang des Umschaltkontaktes verbunden ist, der erste Ausgang des Umschaltkontaktes mit der ersten Elektrode des Speicherkondensators, die erste Elektrode des Speicherkondensators einerseits über ein Widerstandsnetzwerk mit der Spannungsquelle und andererseits mit dem ersten Eingang der Auswertestufe und die zweite Elektrode des Speicherkondensators mit einem Bezugspotential verbunden sind, wobei die zweite Elektrode des kapazitiven Schaltungs- oder Bauelementes ein externes Objekt darstellt und die gesuchte Kapazität zwischen der ersten Elektrode und der durch das externe Objekt gebildeten Masse liegt.

Im Rahmen der Erfindung ist mit "Kapazität" der Kapazitätswert eines kapazitiven Schaltungs- oder Bauelementes gemeint; eine "Kapazitätsänderung" meint folglich eine Änderung des Kapazitätswertes eines kapazitiven Schaltungs- oder Bauelementes. Mit "Erfassung" der Kapazität bzw. einer Kapazitätsänderung ist im Rahmen der Erfindung sowohl eine nur qualitative Erfassung als auch eine quantitative Erfassung, also eine echte Messung, gemeint. "Kapazitives Schaltungs- oder Bauelement" meint im Rahmen der Erfindung jedes Schaltungselement und jedes Bauelement, das kapazitive Eigenschaften hat, häufig auch als Kapazität bezeichnet wird, wobei dann nicht der Kapazitätswert gemeint ist. Ein "kapazitives Schaltungs- oder Bauelement" ist insbesondere ein Kondensator. Als "kapazitives Schaltungs- oder Bauelement" wird im Rahmen der Erfindung aber auch die Elektrode eines kapazitiven Näherungsschalters, im Zusammenwirken mit einem Beeinflussungskörper, bezeichnet. "Kapazitives Schaltungs- oder Bauelement" meint im Rahmen der Erfindung z. B. aber auch die Kapazität, die miteinander kapazitiv wirkende Leitungen darstellen. Nachfolgend wird statt von einem "kapazitiven Schaltungs- oder Bauelement" immer von einem Sensorkondensator gesprochen, ohne daß damit eine Einschränkung auf einen Kondensator im engeren Sinne verbunden ist.

Im Rahmen der Erfindung ist mit "Spannungsquelle" sowohl eine Spannungsquelle insgesamt als auch ein Anschluß einer solchen Spannungsquelle gemeint.

Schließlich sei erläuternd noch angeführt, daß im Rahmen der Erfindung mit "Umschaltkontäkt" ein Schalter gemeint ist, der häufig auch als Wechsler bezeichnet wird, der also einen Eingang und zwei Ausgänge aufweist, wobei der Eingang entweder mit dem ersten Ausgang oder mit dem zweiten Ausgang verbunden ist.

Die eingangs beschriebene Schaltungsanordnung ist aus der deutschen Offenlegungsschrift 40 39 006 bekannt, jedoch ist die darin beschriebene Schaltungsanordnung zur Verwendung bei einem kapazitiven Näherungsschalter weder bestimmt noch besonders geeignet. Sie dient vielmehr als Kapazitäts-Frequenz-Wandler zum Erzeugen eines im wesentlichen rechteckförmigen Wandlerausgangssignals mit einer von der Kapazität eines zu messenden Kondensators abhängigen Frequenz.

Aus der deutschen Offenlegungsschrift 197 01 899 ist ebenfalls eine Schaltungsanordnung mit den oben beschriebenen Merkmalen bekannt. Zwischen den Eingängen der Auswertestufe der hier beschriebenen Schaltungsanordnung können jedoch bei Betätigung des Umschalters Spannungshübe auftreten, die beispielsweise im Zusammenhang mit parasitären Kapazitäten das durch Auswertung der Spannung gewonnene Meßergebnis ungewollt beeinflussen.

Der Erfindung liegt nun die Aufgabe zugrunde, eine Schaltungsanordnung der in Rede stehenden Art anzugeben, die zur Verwendung bei einem kapazitiven Näherungsschalter besonders geeignet ist, aber auch anderweitig vorteilhaft verwendet werden kann, mit deren Hilfe aber auch Störeinflüsse, wie zum Beispiel Bauteiltoleranzen oder Temperaturdrift, bei der Messung kompensiert werden können.

Die erfindungsgemäße Schaltungsanordnung ist zunächst und im wesentlichen da**durch gekennzeichnet, daß** der zweite Ausgang des Umschaltkontaktes mit dem zweiten Eingang der Auswertestufe verbunden ist, daß die Auswertestufe für eine Stromauswertung ausgelegt ist, daß an den Ausgängen des Umschaltkontaktes - und damit an den Eingängen der Auswertestufe - quasi keine Spannungsdifferenz auftritt und daß an die Elektrode des kapazitiven Schaltungs- oder Bauelements kapazitiv eine mit der Umschaltfrequenz des Taktgenerator synchronisierte Hilfsspannung angekoppelt wird.

Bei Schaltungsanordnungen der eingangs beschriebenen Art treten besonders im Bereich des Sensorkondensators eine Vielzahl von parasitären Kapazitäten auf, die das Meßergebnis verfälschen können. Grundsätzlich können sich solche parasitären Kapazitäten nur dann auf das Meßergebnis auswirken, wenn ein Spannungshub auftritt und die dabei aufgenommene bzw. veränderte Ladungsmenge auf das Meßergebnis Auswirkungen hat. Wird ein derartiger Spannungshub verhindert, so können sich die der Schaltungsanordnung anhaftenden parasitären Kapazitäten nicht mehr auswirken. Somit besteht ein erster wesentlicher Vorteil der Schaltungsanordnung gemäß der Lehre der Erfindung darin, daß der für das Meßergebnis negative Einfluß der parasitären Kapazitäten ganz bzw. größtenteils vermieden wird.

Wenn, wie oben ausgeführt, am Eingang des Umschaltkontaktes kein Spannungshub auftritt, bedeutet dies, daß der Sensorkondensator nicht sensitiv ist und somit beispielsweise ein Näherungsschalter ein sich in der Nähe befindliches Objekt nicht detektieren würde. Aus diesem Grunde wird bei der erfindungsgemäßen Schaltungsanordnung eine Hilfsspannung an das kapazitive Schaltungs- oder Bauelement angelegt, die mit der Umschaltfrequenz des Taktgenerators synchronisiert ist. Dadurch, daß durch die angelegte Hilfsspannung am Eingang des Umschaltkontaktes und somit auch am Sensorkondensator ein Spannungshub auftritt, kann die Kapazität bzw. eine Kapazitätsänderung des Sensorkondensators gemessen werden.

Gemäß einer bevorzugten, besonders vorteilhaften Ausführung der Erfindung wird die Hilfsspannung zeitweise abgeschaltet und aus dem dann verbleibenden Meßwert ein Kompensationsmeßwert generiert. Wird die Hilfsspannung abgeschaltet, so wird der Sensorkondensator elektrisch von der Außenwelt getrennt, und es wirken sich nur noch Einflüsse aus, die innerhalb der Schaltungsanordnung entstehen. Der dann verbleibende Meßwert enthält alle Offsetfehler der gesamten Schaltungsanordnung, wie zum Beispiel Bauteiltoleranzen, Fertigungstoleranzen oder Temperatureinflüsse. Der aus all diesen Störeinflüssen resultierende verbleibende Meßwert kann nun als neuer "Nullwert" gespeichert werden und für die weitere Messung als Referenz genommen werden. Für einen derartigen Kompensationszyklus sind neben dem Abschalten der Hilfsspannung verschiedene Techniken denkbar, die alle auf der Modulation der Hilfsspannung beruhen, um aus dem aktuell gemessenen Wert den tatsächlichen Kapazitätswert bzw. die tatsächliche Kapazitätsänderung des Sensorkondensators zu ermitteln, wobei dann alle unvermeidlichen Offseteinflüsse ausgeblendet sind. Möglich ist beispielsweise eine Phasen- oder Amplitudenmodulation der Hilfsspannung ebenso wie eine Phasenumkehr der Hilfsspannung um 180° synchron zum Schaltzeitpunkt des Umschaltkontaktes.

Eine zusätzliche Verbesserung erfährt die erfindungsgemäße Schaltungsanordnung dadurch, daß ein mit der Ausgangsstufe verbundener Referenzzweig zur Messung einer Referenzkapazität mit einem zweiten Umschaltkontakt, einem zweiten Speicherkondensator und einem zweiten Widerstandsnetzwerk vorgesehen ist. Dabei sind der Referenzkondensator, der zweite Umschaltkontakt, der zweite Speicherkondensator und das zweite Widerstandsnetzwerk in gleicher Weise miteinander verbunden, wie der Sensorkondensator, der erste Umschaltkontakt, der erste Speicherkondensator und das erste Widerstandsnetzwerk miteinander verbunden sind und darüber hinaus ist die erste Elektrode des zweiten Speicherkondensators mit dem zweiten Eingang der Auswertestufe verbunden. Wird die erfindungsgemäße Schaltungsanordnung ohne einen solchen Referenzzweig ausgeführt, so ist sie zwar sehr einfach und aufgrund der geringen Bauteilanzahl auch sehr kostengünstig zu realisieren, sie erfordert jedoch ein relativ großes Nutzsignal, da keine Differenzbildung möglich ist. Eine solche Schaltungsanordnung kann jedoch, insbesondere in Verbindung mit der möglichen Ausnutzung eines Kompensationszyklus, eine kostengünstige Alternative eines beispielsweise als Handtaster genutzten Näherungsschalters sein.

Durch die Anordnung eines parallelen Referenzzweiges, der mit dem gleichen Taktgenerator verbunden ist, stehen zwei voneinander vollkommen getrennte Meßkanäle zur Verfügung, die sich nicht gegenseitig beeinflussen. Die Ausgänge der beiden Meßkanäle können dann im Sinne eines Differenzsignals der Auswertestufe zugeführt werden.

Wie bei der Verwendung eines einzigen Meßkanals können auch bei Verwendung eines zusätzlichen Referenzkanals beide Schaltzyklen eines jeden Kanals aktiv genutzt werden, so daß trotz niederfrequenter Störungen ein möglichst reines Gleichtaktsignal zustande kommt, welches mit geeigneter Verstärkertechnik durch Gleichtaktunterdrückung vom Nutzsignal getrennt werden kann. Vorteilhaft für eine gute Gleichtaktunterdrückung eines niederfrequenten Störsignals ist außerdem, wenn beide Schaltzyklen zeitlich gleich lang sind, d. h. der Taktgenerator ein Tastverhältnis von ca. 50 % liefert.

Gemäß einer bevorzugten Ausführung der Erfindung wird der zweite Ausgang des ersten Umschaltkontaktes mit dem ersten Ausgang des zweiten Umschaltkontaktes und der erste Ausgang des ersten Umschaltkontaktes mit dem zweiten Ausgang des zweiten Umschaltkontaktes verbunden. Eine derartige Verschaltung des Meßkanals und des Referenzkanals liefert zwei aktive Ausgänge, die für eine gute Niederfrequenzstörunterdrückung genutzt werden können, wobei gleichzeitig zwei Meßeingänge vorhanden sind, wie es für Näherungsschalter besonders vorteilhaft ist. Der Nutzstrom in dem einen Schaltzyklus wird direkt vom Nutzstrom im zweiten Schaltzyklus abgezogen, ohne daß eine vorherige Verstärkung notwendig ist, die unter Umständen eine Verzerrung des Meßsignals liefern könnte.

Die Ankopplung der Hilfsspannung an das kapazitive Schaltungs- oder Bauelement ist auf unterschiedliche Weise möglich. So kann beispielsweise die Hilfsspannung über eine externe Sondenkonstruktion an die eine Elektrode des Sensorkondensators angekoppelt werden. Dann ist im Bedarfsfall diese Elektrode als kapazitiv unempfindliche Empfangselektrode realisierbar, da sie keine Spannungshübe ausführen muß. Alternativ kann die Ankopplung der Hilfsspannung jedoch auch über einen internen Koppelkondensator an die eine Elektrode des Sensorkondensators erfolgen. Die dann vorliegende Reihenschaltung aus Koppelkondensator und Sensorkondensator stellt einen kapazitiven Spannungsteiler dar, so daß der Spannungshub an der einen Elektrode des Sensorkondensators von dessen Kapazitätswert abhängt. Eine Veränderung des Spannungshubes bewirkt dann einen Stromfluß durch einen der Elektrode des Sensorkondensators nachgeschalteten Widerstand und damit die benötigte Stromvariation im Meßkanal.

Gemäß einer weiteren Ausführung der Erfindung besteht die Auswertestufe aus einem Differenzstromverstärker, dem ein Mikroprozessor nachgeschaltet ist. Enthält die erfindungsgemäße Schaltungsanordnung eine solche Auswertestufe, dann kann der weiter oben beschriebene Kompensationszyklus besonders effektiv ausgenutzt werden. Es ist dann beispielsweise möglich, einen solchen Kompensationszyklus in bestimmten Zeitabständen oder durch bestimmte Ereignisse getriggert auszulösen und den dann erhaltenen neuen "Nullwert" im Mikroprozessor zu speichern und für die nächsten Messungen als Referenz zu benutzen.

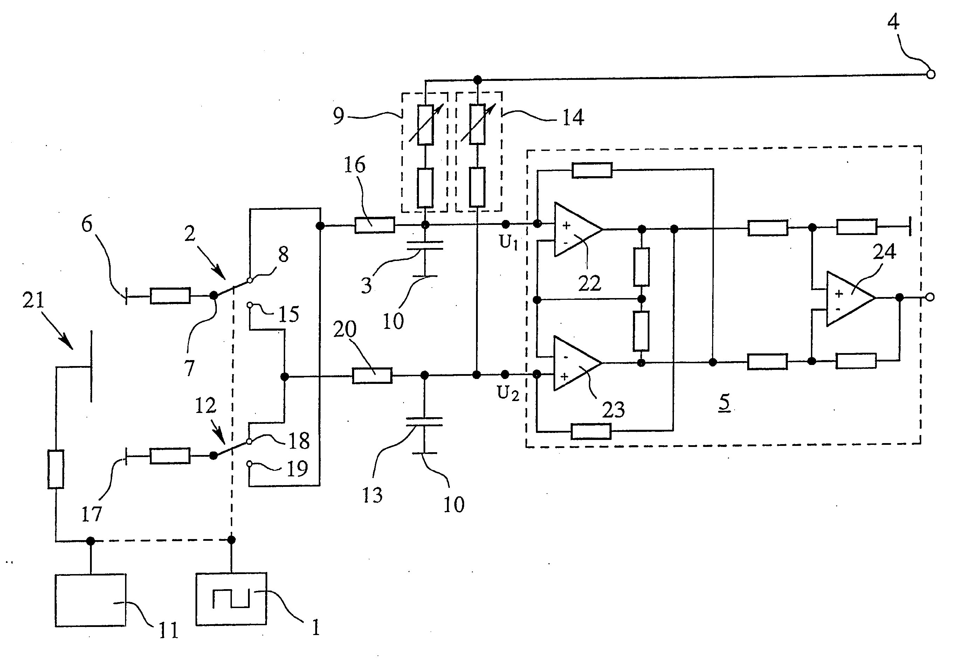

Im einzelnen gibt es nun eine Vielzahl von Möglichkeiten, die Schaltungsanordnung gemäß der Lehre der Erfindung auszugestalten und weiterzubilden. Dazu wird verwiesen einerseits auf die dem Patentanspruch 1 nachgeordneten Patentansprüche, andererseits auf die Beschreibung eines bevorzugten Ausführungsbeispiels in Verbindung mit der Zeichnung. Die einzige Figur der Zeichnung enthält ein bevorzugtes Ausführungsbeispiel einer Schaltungsanordnung zur Messung einer Kapazität nach der Lehre der Erfindung.

Die Schaltungsanordnung besteht nun aus einem Taktgenerator 1, einem von dem Taktgenerator 1 gesteuerten Umschaltkontakt 2, einer Speicherkapazität 3, einer Spannungsquelle 4 und einer Ausgangsstufe 5. Eine Elektrode 6 der gesuchten Kapazität ist mit dem Eingang 7 des Umschaltkontaktes 2 verbunden. Die zweite Elektrode des Sensorkondensators stellt ein hier nicht dargestelltes externes Objekt dar. Die gesuchte Kapazität liegt dann zwischen der Elektrode 6 und der durch das externe Objekt gebildeten Masse. Der erste Ausgang 8 des Umschaltkontaktes 2 ist mit der ersten Elektrode des Speicherkondensators 3 verbunden. Diese Elektrode ist einerseits über ein Widerstandsnetzwerk 9 mit der Spannungsquelle 4 und andererseits mit der Auswertestufe 5 verbunden. Die zweite Elektrode des Speicherkondensators 3 liegt auf Bezugspotential 10. In dem hier dargestellten Ausführungsbeispiel einer Schaltungsanordnung entspricht das Bezugspotential 10 Masse.

Weiter weist die in der Zeichnung dargestellte Schaltungsanordnung eine Hilfsspannung 11 auf, die mit der Umschaltfrequenz des Taktgenerators 1 synchronisiert ist. Der Hilfsspannung 11 kann zusätzlich ein nicht dargestellter Frequenz- oder Amplitudenmodulator nachgeschaltet sein. Im vorliegenden Fall wird die Hilfsspannung 11 über eine externe Sondenkonstruktion 21 an die Elektrode 6 des kapazitiven Schaltungs- oder Bauelements angekoppelt.

Die in der Zeichnung dargestellte Schaltungsanordnung enthält weiter einen zweiten Umschaltkontakt 12, einen zweiten Speicherkondensator 13 und ein zweites Widerstandsnetzwerk 14. Somit besteht die Schaltungsanordnung aus einem Meßzweig und einem Referenzzweig. Zu dem Meßzweig gehören der erste Umschaltkontakt 2 mit dem Eingang 7, dem ersten Ausgang 8 und einem zweiten Ausgang 15 sowie der Sensorkondensator, dessen eine Elektrode 6 dargestellt ist, ferner der Speicherkondensator 3 und das Widerstandsnetzwerk 9 sowie ein zusätzlicher Widerstand 16. Zu dem Referenzzweig gehören zunächst ein Referenzkondensator, dessen eine Elektrode 17 dargestellt ist, der zweite Umschaltkontakt 12 mit einem ersten Ausgang 18 und einem zweiten Ausgang 19, der zweite Speicherkondensator 13 und das zweite Widerstandsnetzwerk 14 sowie ein weiterer Widerstand 20. Die zweite Elektrode des Referenzkondensators stellt, wie bei dem Sensorkondensator, das hier nicht dargestellte externe Objekt dar. Der Referenzkondensator insgesamt kann jedoch auch durch einem Festkondensator gebildet werden.

Über die beiden Widerstandsnetzwerke 9 und 14, die je einen einstellbaren Widerstand enthalten, kann der optimale Arbeitspunkt eingestellt werden. Beide Widerstandsnetzwerke 9 und 14 sollten vorteilhafterweise in etwa gleich groß sein.

Bei dem in der Figur dargestellten Ausführungsbeispiel einer erfindungsgemäßen Schaltungsanordnung sind der zweite Ausgang 15 des ersten Umschaltkontaktes 2 mit dem ersten Ausgang 18 des zweiten Umschaltkontaktes 12 und der erste Ausgang 8 des ersten Umschaltkontaktes 2 mit dem zweiten Ausgang 19 des zweiten Umschaltkontaktes 12 verbunden.

Als Auswertestufe 5 kann grundsätzlich jede potentialfreie Strommeßschaltung mit vernachlässigbarem Spannungsabfall zwischen ihren Eingängen benutzt werden. Eine solche Verstärkerschaltung kann beispielsweise ein StromSpannungswandler sein.

Die in der Figur dargestellte Auswertestufe 5 besteht aus einer Differenzstromverstärkerschaltung mit zwei Operationsverstärkern 22 und 23 und einem nachgeschalteten, als Subtrahierer arbeitenden dritten Operationsverstärker 24. Durch die interne Verschaltung der Auswertestufe 5 wird dafür gesorgt, daß die Spannung U₁ am nicht invertierten Eingang des Operationsverstärkers 22 der Spannung U₂ am nicht invertierten Eingang des Operationsverstärkers 23 entspricht. Im übrigen kann dem Operationsverstärker 24, was hier nicht dargestellt ist, ein Mikroprozessor nachgeschaltet werden. Ein solcher Mikroprozessor kann dazu benutzt werden, den Kompensationzyklus, d. h. das Abschalten der Hilfsspannung bzw. das Modulieren der Hilfsspannung, zu steuern. Mit einem solchen Mikroprozessor ist es dann möglich, den Kompensationszyklus in bestimmten Zeitabständen oder durch bestimmte Ereignisse getriggert auszulösen.

Sowohl an den Meßkanal als auch an den Referenzkanal können jeweils vor die Umschaltkontakte 2 bzw. 12 zur Unterdrückung von hochfrequenten Störanteilen - hier nicht dargestellte - RC-Tiefpässe geschaltet werden. Auch hier wirkt es sich positiv aus, daß an den Umschaltkontakten 2 bzw. 12 keine Spannungshübe auftreten, so daß ohne nennenswerte Beeinflussung des Meßwertes kleinere Kapazitäten in den Meß- bzw. Referenzkanal geschaltet werden können. daß ohne nennenswerte Beeinflussung des Meßwertes kleinere Kapazitäten in den Meß- bzw. Referenzkanal geschaltet werden können.

Weiter oben ist ausgeführt worden, daß die Hilfsspannung, die an das kapazitive Schaltungs- oder Bauelement angelegt wird, mit der Umschaltfrequenz des Taktgenerators synchronisiert ist. Dabei kann die Hilfsspannung gegenüber der Spannung des Taktgenerators auch zeitverzögert oder phasenverschoben sein, vorzugsweise phasenverschoben um 90°, weil das besonders einfach und zuverlässig aus der doppelten Umschaltfrequenz des Taktgenerators gewonnen werden kann. Mit dieser Maßnahme können die temperaturbedingten Einflüsse auf die Gatterlaufzeiten der Umschaltkontakte minimiert werden, wenn dafür gesorgt ist, daß zum Umschaltzeitpunkt der auszuwertende Ladungstransport im wesentlichen abgeschlossen ist. Das bedeutet, daß eine geringfügige Änderung der Gatterlaufzeit keine Änderung des gemessenen Stromintegrals zwischen den Umschaltzeitpunkten mehr bewirkt.

## Patentansprüche

1. Schaltungsanordnung zur Erfassung der Kapazität bzw. einer Kapazitätsänderung eines kapazitiven Schaltungs- oder Bauelementes, mit einem Taktgenerator (1), einem von dem Taktgenerator (1) gesteuerten Umschaltkontakt (2), einem Speicherkondensator (3), einer Spannungsquelle (4) und einer Auswertestufe (5) mit zwei Eingängen, bei der eine Elektrode (6) des kapazitiven Schaltungs- oder Bauelementes mit dem Eingang (7) des Umschaltkontaktes (2) verbunden ist, der erste Ausgang (8) des Umschaltkontaktes (2) mit der ersten Elektrode des Speicherkondensators (3), die erste Elektrode des Speicherkondensators (3) einerseits über ein Widerstandsnetzwerk (9) mit der Spannungsquelle (4) und andererseits mit dem ersten Eingang der Auswertestufe (5) und die zweite Elektrode des Speicherkondensators (3) mit einem Bezugspotential (10) verbunden sind, wobei die zweite Elektrode des kapazitiven Schaltungs- oder Bauelementes ein externes Objekt darstellt, und die gesuchte Kapazität zwischen der ersten Elektrode und der durch das externe Objekt gebildeten Masse liegt, **dadurch gekennzeichnet, daß** der zweite Ausgang (15) des Umschaltkontaktes (2) mit dem zweiten Eingang der Auswertestufe (5) verbunden ist, daß die Auswertestufe (5) für eine Stromauswertung ausgelegt ist, daß an den Ausgängen (8 und 15) des Umschaltkontaktes (2) - und damit an den Eingängen der Auswertestufe (5) - quasi keine Spannungsdifferenz auftritt und daß an die Elektrode (6) des kapazitiven Schaltungs- oder Bauelements kapazitiv eine mit der Umschaltfrequenz des Taktgenerators (1) synchronisierte Hilfsspannung (11) angekoppelt wird.

2. Schaltungsanordnung nach Anspruch 1, **dadurch gekennzeichnet, daß** die Hilfsspannung (11) zeitweise abgeschaltet wird und aus dem dann verbleibenden Meßwert ein Kompensationsmeßwert generiert wird.

3. Schaltungsanordnung nach Anspruch 1 oder 2, **dadurch gekennzeichnet, daß** die Hilfsspannung (11) moduliert wird.

4. Schaltungsanordnung nach einem der Ansprüche 1 bis 3 **dadurch gekennzeichnet, daß** die Hilfsspannung (11) gegenüber der Spannung des Taktgenerators (1) zeitverzögert oder phasenverschoben wird, vorzugsweise um 90° phasenverschoben wird.

5. Schaltungsanordnung nach einem der Ansprüche 1 bis 4, **dadurch gekennzeichnet, daß** ein Referenzkondensator, ein zweiter Umschaltkontakt (12), ein zweiter Speicherkondensator (13) und ein zweites Widerstandsnetzwerk (14) vorgesehen sind, daß der Referenzkondensator, der zweite Umschaltkontakt (12), der zweite Speicherkondensator (13) und das zweite Widerstandsnetzwerk (14) in gleicher Weise miteinander verbunden sind wie der Sensorkondensator, der erste Umschaltkontakt (2), der erste Speicherkondensator (3) und das erste Widerstandsnetzwerk (9) miteinander verbunden sind, und daß die erste Elektrode des zweiten Speicherkondensators (13) mit dem zweiten Eingang der Auswertestufe (5) verbunden ist, und daß der zweite Ausgang (15) des ersten Umschaltkontaktes (2) mit dem ersten Ausgang (18) des zweiten Umschaltkontaktes (12) und der erste Ausgang (8) des ersten Umschaltkontaktes (2) mit dem zweiten Ausgang (19) des zweiten Umschaltkontaktes (12) verbunden sind.

6. Schaltungsanordnung nach einem der Ansprüche 1 bis 5, **dadurch gekennzeichnet, daß** die Hilfsspannung (11) über eine externe Sondenkonstruktion (21) an das kapazitive Schaltungs- oder Bauelement angekoppelt wird.

7. Schaltungsanordnung nach einem der Ansprüche 1 bis 5, **dadurch gekennzeichnet, daß** die Hilfsspannung (11) über einen internen Koppelkondensator an das kapazitive Schaltungs- oder Bauelement angekoppelt wird.

8. Schaltungsanordnung nach einem der Ansprüche 1 bis 7, **dadurch gekennzeichnet, daß** die Auswertestufe (5) aus einem Differenzstromverstärker besteht und dem Differenzstromverstärker ein Mikroprozessor nachgeschaltet ist.

## Claims

1. Circuit arrangement for detecting the capacitance or a change in capacitance of a capacitive circuit element or component, having a clock generator (1), a changeover contact (2) which is controlled by the clock generator (1), a storage capacitor (3), a voltage source (4) and an evaluation stage (5) having two inputs, in which one electrode (6) of the capacitive circuit element or component is connected to the input (7) of the changeover contact (2), the first output (8) of the changeover contact (2) is connected to the first electrode of the storage capacitor (3), the first electrode of the storage capacitor (3) is connected, on the one hand, to the voltage source (4) via a resistance network (9) and, on the other hand, to the first input of the evaluation stage (5), and the second electrode of the storage capacitor (3) is connected to a reference-earth potential (10), the second electrode of the capacitive circuit element or component constituting an external object, and the capacitance sought being between the first electrode and the earth formed by the external object, **characterized in that** the second output (15) of the changeover contact (2) is connected to the second input of the evaluation stage (5), **in that** the evaluation stage (5) is designed to evaluate current, **in that** there is virtually no voltage difference at the outputs (8 and 15) of the changeover contact (2) and thus at the inputs of the evaluation stage (5), and **in that** an auxiliary voltage (11) which is synchronized with the changeover frequency of the clock generator (1) is capacitively coupled to the electrode (6) of the capacitive circuit element or component.

2. Circuit arrangement according to Claim 1, **characterized in that** the auxiliary voltage (11) is temporarily switched off and a compensation measured value is generated from the measured value which then remains.

3. Circuit arrangement according to Claim 1 or 2, **characterized in that** the auxiliary voltage (11) is modulated.

4. Circuit arrangement according to one of Claims 1 to 3, **characterized in that** the auxiliary voltage (11) is temporally delayed or phase-shifted, preferably phase-shifted through 90°, with respect to the voltage of the clock generator (1).

5. Circuit arrangement according to one of Claims 1 to 4, **characterized in that** a reference capacitor, a second changeover contact (12), a second storage capacitor (13) and a second resistance network (14) are provided, **in that** the reference capacitor, the second changeover contact (12), the second storage capacitor (13) and the second resistance network (14) are connected to one another in the same manner as the sensor capacitor, the first changeover contact (2), the first storage capacitor (3) and the first resistance network (9), and **in that** the first electrode of the second storage capacitor (13) is connected to the second input of the evaluation stage (5), and **in that** the second output (15) of the first changeover contact (2) is connected to the first output (18) of the second changeover contact (12), and the first output (8) of the first changeover contact (2) is connected to the second output (19) of the second changeover contact (12).

6. Circuit arrangement according to one of Claims 1 to 5, **characterized in that** the auxiliary voltage (11) is coupled to the capacitive circuit element or component via an external probe construction (21).

7. Circuit arrangement according to one of Claims 1 to 5, **characterized in that** the auxiliary voltage (11) is coupled to the capacitive circuit element or component via an internal coupling capacitor.

8. Circuit arrangement according to one of Claims 1 to 7, **characterized in that** the evaluation stage (5) comprises a differential current amplifier, and a microprocessor is connected downstream of the differential current amplifier.

## Revendications

1. Circuit pour enregistrer la capacité ou une variation de capacité d'un circuit ou d'un composant capacitif, avec un générateur d'horloge (1), un contact de commutation (2) piloté par le générateur d'horloge (1), un condensateur de stockage (3), une source de tension (4) et un étage de traitement (5) à deux entrées, dans lequel une électrode (6) du circuit ou du composant capacitif est reliée à l'entrée (7) du contact de commutation (2), la première sortie (8) du contact de commutation (2) est reliée à la première électrode du condensateur de stockage (3), la première électrode du condensateur de stockage (3) est reliée d'une part à la source de tension (4) par l'intermédiaire d'un réseau de résistances (9) et d'autre part à la première entrée de l'étage de traitement (5) et la deuxième électrode du condensateur de stockage (3) est reliée à un potentiel de référence (10), dans lequel la deuxième électrode du circuit ou du composant capacitif représente un objet externe, et la capacité recherchée se trouvant entre la première électrode et la masse constituée par l'objet externe **caractérisé en ce que** la deuxième sortie (15) du contact de commutation (2) est reliée à deuxième entrée de l'étage de traitement (5), **en ce que** l'étage de traitement (5) est conçu pour un traitement du courant, **en ce qu'**il n'apparaît quasiment aucune différence de tension aux sorties (8 et 15) du contact de commutation (2) et ainsi aux entrées de l'étage de traitement (5) et **en ce qu'**une tension auxiliaire (11) synchronisée avec la fréquence de commutation du générateur d'horloge (1) est couplée capacitivement à l'électrode (6) du circuit ou du composant capacitif.

2. Circuit selon la revendication 1, **caractérisé en ce que** la tension auxiliaire (11) est coupée périodiquement et qu'à partir de la valeur de mesure restante on génère alors une valeur de mesure de compensation.

3. Circuit selon la revendication 1 ou 2, **caractérisé en ce que** la tension auxiliaire (11) est modulée.

4. Circuit selon une des revendications 1 à 3, **caractérisé en ce que** la tension auxiliaire (11) est retardée ou décalée en phase, de préférence décalée en phase de 90° par rapport à la tension du générateur d'horloge (1).

5. Circuit selon une des revendications 1 à 4, **caractérisé en ce qu'**on a prévu un condensateur de référence, un deuxième contact de commutation (12), un deuxième condensateur de stockage (13) et un deuxième réseau de résistances (14), **en ce que** le condensateur de référence, le deuxième contact de commutation (12), le deuxième condensateur de stockage (13) et le deuxième réseau de résistances (14) sont reliés entre eux de la même manière que le condensateur capteur, le premier contact de commutation (2), le premier condensateur de stockage (3) et le premier réseau de résistances (9), et **en ce que** la première électrode du deuxième condensateur de stockage (13) est reliée à la deuxième entrée de l'étage de traitement (5), et **en ce que** la deuxième sortie (15) du premier contact de commutation (2) est reliée à la première sortie (18) du deuxième contact de commutation (12) et la première sortie (8) du premier contact de commutation (2) est reliée à la deuxième sortie (19) du deuxième contact de commutation (12).

6. Circuit selon une des revendications 1 à 5, **caractérisé en ce que** la tension auxiliaire (11) est couplée au circuit ou au composant capacitif par l'intermédiaire d'une construction de sonde externe (21).

7. Circuit selon une des revendications 1 à 5, **caractérisé en ce que** la tension auxiliaire (11) est couplée au circuit ou au composant capacitif par l'intermédiaire d'un condensateur de couplage interne.

8. Circuit selon une des revendications 1 à 7, **caractérisé en ce que** l'étage de traitement (5) est constitué d'un amplificateur de courant différentiel et qu'un microprocesseur est branché en aval de l'amplificateur de courant différentiel.
